(19) Europäisches Patentamt

European Patent Office

Office européen des brevets

(11) **EP 0 779 706 B1**

(12) **EUROPÄISCHE PATENTSCHRIFT**

(45) Veröffentlichungstag und Bekanntmachung des Hinweises auf die Patenterteilung:
**09.10.2002 Patentblatt 2002/41**

(51) Int Cl.⁷: **H03G 9/02**, H03G 5/00

(21) Anmeldenummer: **96119341.4**

(22) Anmeldetag: **03.12.1996**

(54) **Schaltungsanordnung zur Verbesserung des Störabstandes**

Circuitry for improving signal to noise ratio

Circuit pour augmenter le rapport signal bruit

(84) Benannte Vertragsstaaten:
**DE FR GB IT**

(30) Priorität: **16.12.1995 DE 19547093**

(43) Veröffentlichungstag der Anmeldung:
**18.06.1997 Patentblatt 1997/25**

(73) Patentinhaber: **NOKIA TECHNOLOGY GmbH 44718 Bochum (DE)**

(72) Erfinder: **Stuhlfelner, Friedbert 94339 Leiblfing (DE)**

(74) Vertreter:
**TER MEER STEINMEISTER & PARTNER GbR Patentanwälte, Mauerkircherstrasse 45 81679 München (DE)**

(56) Entgegenhaltungen:
EP-A- 0 599 132 US-A- 4 641 361
US-A- 4 852 175 US-A- 5 027 410
US-A- 5 083 312

**Beschreibung**

Zum Aufzeichnen oder Verstärken von Schallereignissen ist es erforderlich, die Schallereignisse zunächst mit Hilfe elektroakustischer Wandler in ein elektrisches Signal umzuwandeln. Das so gewonnene elektrische Signal wird entweder weiterverstärkt und zwecks Rückgewinnung des verstärkten Schallsignals in einem weiteren elektroakustischen Wandler zurückgewandelt oder zunächst auf einem Datenträger zwischengespeichert, ehe es zum Schallsignal zurückkonvertiert wird.

Der zwischen beiden Signalwandlungen enthaltene elektrische Kanal verändert das Signal insofern, als er dem Signal zumindest Rauschen zufügt. Das Rauschen setzt sich zusammen einerseits aus dem thermischen Rauschen der Bauelemente, und ist somit bei gegebenem Innenwiderstand ausschließlich von der Temperatur abhängig, sowie dem Quantisierungsrauschen, falls das elektrische Signal von der analogen in die digitale Form bzw. zurückgewandelt wird. Auch die Signalamplitude des letztgenannten Rauschsignals ist von der Amplitude des Nutzsignals oder Audiosignals unabhängig.

Für das Ohr ist die Rauschsignalkomponente solange nicht störend, wie sie nennenswert unter der Amplitude des Nutzsignals bleibt. Das Ohr hat die Fähigkeit, Signale auszublenden, wenn die Signalamplitude deutlich unter einem Signal mit größerer Amplitude zurückbleibt. Dieser Ausblendeffekt ist, abgesehen von der Amplitudenabhängigkeit, auch frequenzabhängig.

Es wurden deswegen in der Vergangenheit bereits viele Versuche unternommen, diese Eigenschaft des menschlichen Gehörs auszunutzen, um subjektiv den Störabstand zu verbessern.

Eines der ältesten Verfahren zur subjektiven Verbesserung des Störabstandes besteht darin, das Audiofrequenzspektrum in zwei Kanäle aufzuteilen, wobei die Frequenzgrenze bei ca. 8 kHz liegt, und die Verstärkung im Kanal mit der höheren Frequenz sprunghaft auf null zu setzen, wenn das dort vorhandene Nutzsignal unterhalb einer vorbestimmten Schwelle liegt.

Der unangenehme Nebeneffekt dieser vergleichsweise sehr einfachen Schaltung liegt in einer starken Beeinträchtigung der Klangfarbe, weil viele Obertöne im Frequenzbereich über 8 kHz auftreten und durch dieses Verfahren gleichmäßig abgeschnitten werden.

Ein anderes Verfahren, das ebenfalls lediglich mit zwei Kanälen arbeitet, wobei der Kanal mit der höheren Frequenz beeinflußt wird, ist in dem Aufsatz "The SSM 2000 HUSH Noise Reduction System" von Analog Devices beschrieben. Bei diesem System wird mit einem variablen Grenzwert gearbeitet, bei dessen Überschreiten der durch Rauschen gestörte hochfrequente Kanal zugeregelt wird.

Bei diesem System wird ebenfalls die Klangfarbe in unerwünschter Weise hörbar beeinflußt, abgesehen davon, daß Pumpeffekte auftreten können, wenn die Einschwingzeit nicht schnell genug ist.

Bei dem Rauschfilter nach der US-PS 3 803 357 wird der untere und der obere Frequenzbereich unverändert übertragen, während der mittlere Frequenzbereich einem mehrkanaligen System zugeordnet ist. Dieses mehrkanalige System enthält eine Vielzahl von schmalbandigen Bandpaßfiltern, die den gesamten Frequenzbereich zwischen dem Tiefpaß- und dem Hochpaßfilter überdecken. Jedem der schmalbandigen Bandpaßfilter ist ein nicht linearer Verstärker nachgeordnet, dessen Verstärkungsverhältnis einstellbar ist. Die Verstärkungsregelung geschieht mit Hilfe eines "noise trackers", der das Summensignal am Eingang sämtlicher Bandpaßfilter abtastet und gleichsinnig sämtliche der schmalbandigen Kanäle steuert.

Die Verstärkungsregelung bei dem bekannten System besteht darin, in der Umgebung des Nulldurchgangs des Audiosignals eine Lücke zu definieren, während der das Signal am Ausgang null ist. Eingangssignale, die in diese Lücke fallen, werden dadurch nicht verstärkt. Sinussignale und sinusähnliche Signale, deren Amplitude von Scheitel zu Scheitel größer ist als diese tote Zone, werden durchgelassen, bekommen jedoch in dem Signalverlauf in der Umgebung des Nulldurchgangs eine deutliche Stufe oder einen Knick infolge der fehlenden Verstärkung in der Umgebung des Nulldurchgangs. Die dadurch hervorgerufene nichtlineare Verzerrung soll durch ein weiteres Schmalbandfilter am Ausgang des Verstärkers wieder wettgemacht werden.

Der Aufwand ist verhältnismäßig hoch und außerdem erzeugt das System zusätzliche Oberwellen, die sich als erhöhter Störfaktor bemerkbar machen, ähnlich wie bei Gegentaktverstärkerstufen mit Übernahmeverzerrungen.

Ein weiteres Problem bei diesem System sind die Einschwingvorgänge, die bekanntermaßen umso länger dauern, je schmalbandiger das Filter ist. Hieraus resultieren Einschwingverzerrungen, die ebenfalls unerwünscht sind.

In EP-A-0 599 132 ist ein Verfahren zur Unterdrückung von Rauschen in einem Audiosignal beschrieben, bei dem das Audio- Frequenzspektrum in eine Vielzahl von Kanälen, in sogenannte "critical bands" entsprechend den Verdeckungseigenschaften des menschlichen Gehörs, aufgeteilt wird, der momentane Signalpegel in jedem dieser Kanäle überwacht wird und das Signal in diesem Kanal vollständig unterdrückt wird, wenn festgestellt wird, daß in dem betreffenden kritischen Band kein nutzbares Signal vorliegt. Die vollständige Unterdrückung des Signals bei einem Nutzsignalpegel, der unterhalb eines Schwellwerts liegt, bleibt nur dann unhörbar, wenn die "kritische" Bandbreite der Kanäle nicht überschritten wird. Dieses Verfahren ist demnach für einkanalige Anordnungen, bei denen das ganze Audio- Frequenzspektrum in einem einzigen Kanal übertragen wird oder in mehrkanaligen Anordnungen, bei denen jeder Kanal deutlich breiter ist als ein "critical band", nicht einsetzbar.

Die US-PS 5 067 157 beschreibt ein Rauschunterdrükkungssystem, bei dem das Audiosignal wiederum in mehrere schmalbandige Kanäle aufgeteilt wird, abhängig von der Signalamplitude im jeweiligen Kanal wird der Kanal einoder ausgeschaltet.

Ein solchermaßen hart umschaltendes System neigt zu hörbaren Pumpeffekten.

Ausgehend hiervon ist es Aufgabe der Erfindung, eine neue Schaltungsanordnung zur Verbesserung des Störabstandes bei einem Audiosignal zu schaffen, das keine hörbaren Pumpeffekte zeigt.

Mit der neuen Form der Regelung wird eine Verbesserung sowohl erzielt, wenn der geregelte Kanal das gesamte Hörspektrum überträgt, als auch bei Anordnungen, bei denen das Hörspektrum auf mehrere Einzelkanäle aufgeteilt ist, wobei wenigstens einer der Kanäle mit der neuen Regelung versehen ist. Naturgemäß lassen sich die besten Ergebnisse erzielen, wenn das Spektrum auf mehrere Kanäle aufgeteilt ist. Die einkanalige Variante stellt insofern eine besondere Variante der Dynamikkompression bzw. -expansion dar, um den subjektiv hörbaren Rauschabstand zu verbessern.

Pumpeffekte werden bei dem neuen System durch die Kombination einer Reihe von Maßnahmen unterdrückt. Eine der Maßnahmen besteht darin, den Pegel im betreffenden Kanal über eine bestimmte Zeit zu erfassen, womit kurzfristige Änderungen in der Signalamplitude bereits bis zu einem gewissen Grade ausgeglichen werden. Eine weitere Maßnahme, die Pumpen verhindert, besteht darin, die Verstärkung nicht abrupt zu verändern, wenn der über eine längere Zeitspanne gemittelte Signalpegel unter die Schaltschwelle sinkt, sondern stattdessen die Verstärkung, ausgehend von ihrem Maximalwert, exponentiell gegen einen Kleinstwert laufen zu lassen. Umgekehrt wird der betreffende Kanal nicht umgehend wieder mit der Verstärkung eins betrieben, wenn der Signalpegel einen Wert erreicht, der über der Schaltschwelle liegt. Auch in diesem Falle wird die Verstärkung schnell aber nicht sprunghaft von ihrem Kleinstwert wieder auf den Maiximalwert, beispielsweise die Verstärkung eins, hochgesteuert.

Ferner wird es hierdurch möglich, entweder bei gegebenen Analog/Digital-Wandlern den subjektiven Störabstand zu verbessern oder bei gleichen Anforderungen an den subjektiven Störabstand einen Analog/Digital-Wandler einzusetzen, der eine geringere Anzahl von Inkrementen aufweist, d.h. einen Analog/Digital-Wandler, bei dem der Quantisierungssprung größer und deswegen auch das Quantisierungsrauschen an sich höher ist. Durch die oben erwähnten Maßnahmen läßt sich der subjektive Störabstand auf Werte vermindern, wie sie einem Analog/Digital-Wandler mit kleinerem Quantisierungssprung entsprechen.

Ein aus der Sicht der Hörphysiologie besonders vorteilhaftes System wird erhalten, wenn sich der betreffende Kanal innerhalb einer festgelegten Systemzeit scheinbar nicht-kausal verhält. Das bedeutet, daß das System quasi bereits zum Zeitpunkt $t_0$ weiß, welches Ereignis zum Zeitpunkt $t_n$ noch eintreten wird. Die Steuerung wird dadurch zu einer vorausschauenden Steuerung und ermöglicht das Herauf- oder Heruntersteuern der Verstärkung, noch ehe das die Steuerung oder das Audiosignal beeinflussende Ereignis tatsächlich eingetreten ist.

Ein solches scheinbar nicht-kausales Systemverhalten läßt sich erreichen, wenn die Meßmittel, bezogen auf den Signalfluß des Audiosignals, vor den Signalverstärkungsmitteln angeordnet sind. Dadurch kann die Verzögerungszeit in den Verstärkungsmitteln ausgenutzt werden, um mit Hilfe der so erhaltenen Vorwärtsregelung ein scheinbar nicht-kausales Systemverhalten zu erzeugen.

Eine einen längeren Zeitraum berücksichtigende Vorwärtsregelung oder -steuerung wird erhalten, wenn in dem Signalfluß der Audiosignale Verzögerungsmittel enthalten sind.

Der Übergang bei der Verstärkung und eventuell dadurch hervorgerufene Verzerrungen lassen sich auf ein nicht hörbares Minimum verringern, wenn die Verstärkung der Signalverstärkungsmittel nach einer e-Funktion verändert wird.

Eine allmählich an- oder absteigende Verstärkung wird erzielt, wenn die Steuermittel das Verhalten eines Integrators mit exponentieller Kennlinie haben.

Die neue Schaltungsanordnung ist insbesondere dann vorteilhaft anzuwenden, wenn der Audiosignalanteil am Eingang der Pegelmeßmittel als digitalisiertes Signal vorliegt.

Die Schaltungsanordnung läßt sich sehr einfach in einem Digitalprozessor implementieren, in dem sowohl die Pegelmeßmittel als auch die Signalverstärkungsmittel als auch die Vergleichsmittel und die Steuermittel Programme innerhalb des Digitalprozessors sind.

Der Rechenaufwand kann verringert werden, wenn der Digitalprozessor mit Festkörperarithmetik ausgestattet ist und die Eigenschaft besitzt, wahlweise bei der Rechenoperation keine Zahlen zu berechnen, die kleiner oder die größer als ein vorgegebener Zahlenwert sind. Dadurch läßt sich auf einfache Weise die Verstärkungn eins bzw. die Minimalverstärkung verwirklichen, ohne zusätzliche Rechenoperationen zu erfordern.

Der Rechenaufwand für das Berechnen des Signalpegels wird sehr gering, wenn das Programm gemäß der folgenden Gleichung den Signalpegel im betreffenden Kanal ermittelt:

$$\text{Pegel}_{(t+\Delta t)} = k * \text{Pegel}_{(t)} + (1-k) * |\text{Audio}_t|,$$

wobei gilt:

k =          exp $(-t_{sample}/t_{integration})$

$t_{sample}$ =          zeitlicher Abstand zwischen zwei Abtast-

werten

$t_{integration}$ = Integrationszeitkonstante

$Audio_t$ = Amplitude des Audiosignalanteils zum Zeitpunkt t.

Ersichtlicherweise ist pro Abtastwert lediglich eine Multiplikation und eine Addition erforderlich. Alle übrigen Parameter der Gleichung können vorher rechnerisch bestimmt werden und brauchen nicht während der eigentlichen Signalverarbeitung ausgerechnet zu werden.

Die Berechnung der Verstärkung im betreffenden Kanal geschieht zweckmäßigerweise gemäß der nachstehenden Gleichung:

$$Gain_{(t+\Delta t)} = Scaler * (Gain_{(t)} + const.),$$

wobei gilt:

Scaler = $exp(-t_{sample}/t_{Scaler})$

$t_{sample}$ = zeitlicher Abstand zwischen zwei Abtastwerten

$t_{Scaler}$ = Integrationszeitkonstante

$Gain_t$ = Verstärkungsfaktor zum Zeitpunkt t

const = (1/Scaler - 1) * Minimalverstärkung.

Auch hier ist lediglich eine Addition und eine Multiplikation vonnöten, so daß mit vergleichsweise schwachen Digitalprozessoren die Berechnung der erforderlichen Signale in Echtzeit möglich ist.

Im übrigen sind Weiterbildungen der Erfindung Gegenstand von Unteransprüchen.

In der Zeichnung ist ein Ausführungsbeispiel des Gegenstandes der Erfindung dargestellt. Es zeigen:

Fig. 1 ein Blockschaltbild der gesamten Schaltungsanordnung zur Verarbeitung des Audiosignals und

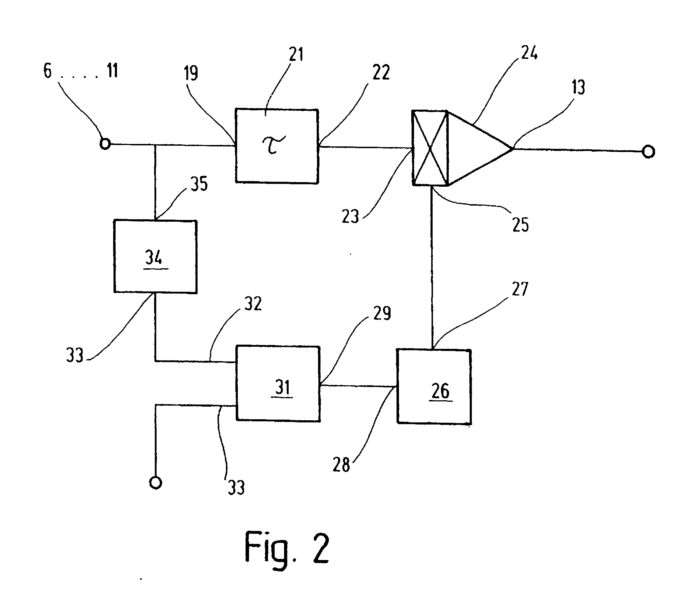

Fig. 2 ein Blockschaltbild für einen der Kanäle der Schaltungsanordnung nach Fig. 1.

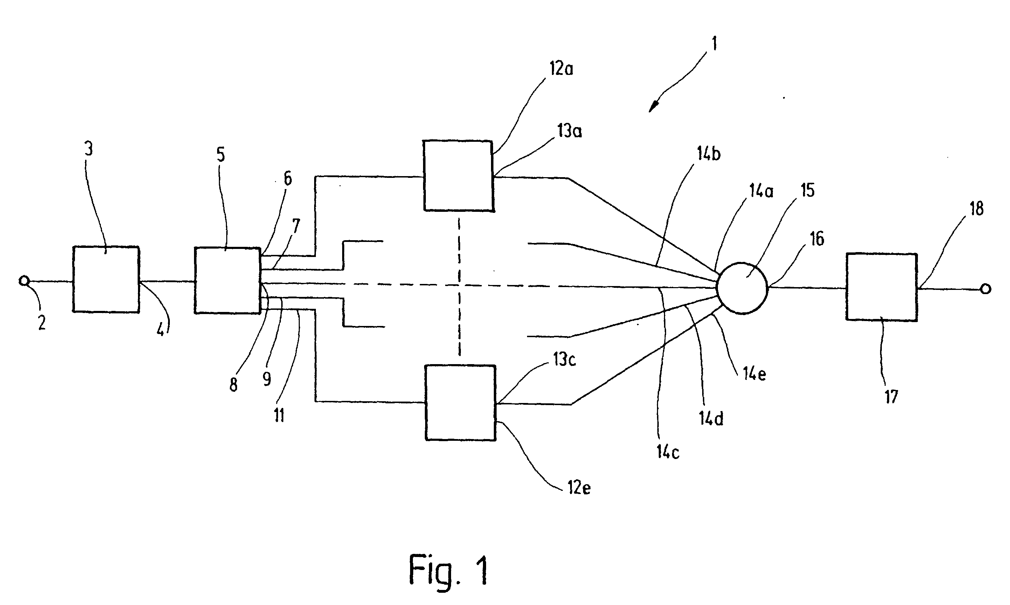

Fig. 1 zeigt einen Ausschnitt aus einer Audioanlage, soweit dies für das Verständnis der Erfindung erforderlich ist. Die in Fig. 1 gezeigte Audioschaltung 1 weist einen Audiosignaleingang 2 auf, in den ein elektrisches Audiosignal eingespeist werden kann, das von einem Mikrofon oder einem beliebigen Speichermedium kommen kann. Das in den Eingang 2 eingespeiste Signal stellt beispielsweise ein Analogsignal dar, das in einem nachgeschalteten Analog/Digital-Wandler 3, der mit seinem Eingang den Eingang 2 darstellt, umgewandelt wird.

Der Analog/Digital-Wandler 3 gibt das Audiosignal in digitalisierter Form an seinem Ausgang 4 ab. Von hier gelangt es in einen Schaltungsblock 5, der die Funktion einer Frequenzweiche mit beispielsweise fünf Ausgängen 6, 7, 8, 9 und 11 hat. In dem Schaltungsblock 5 wird das hörbare Tonfrequenzspektrum zwischen 30 Hz und 20 kHz in fünf Frequenzbänder aufgeteilt. Beispielsweise reicht das Spektrum an dem Anschluß 6 von 30 Hz bis 110 Hz, der Frequenzbereich an dem Ausgang 7 von 110 Hz bis 440 Hz, an dem Ausgang 8 steht das Audiosignal im Frequenzbereich zwischen 440 Hz und 1484 Hz an, während der Ausgang 8 aus dem Audiosignalspektrum den Bereich zwischen 1484 und 5448 Hz und schließlich der Ausgang 11 den Rest des Audiospektrums bis 20 kHz führt.

Selbstverständlich ist der Schaltungsblock 5, wenn er dem Analog/Digital-Wandler 3 nachgeschaltet ist, nicht als hardwaremäßig ausgeführte Frequenzweiche zu denken, sondern der Schaltungsblock 5 ist vielmehr ein Programmteil in einem Digitalprozessor, der das digitalisierte Audiosignal mittels bekannter Algorithmen in seine Frequenzanteile zerlegt. Die Ausgänge 6... 11 sind somit virtuelle Ausgänge eines Programmteils, das in dem Digitalprozessor abläuft und aus dem Audiosignal an dem Eingang 2 die in die entsprechenden Frequenzbereiche fallenden Audiosignalanteile erzeugt. Auch die Audiosignalanteile sind wiederum Digitalsignale.

An jeden der Ausgänge 6...11 ist ein eigener einen Kanal repräsentierender Schaltungsblock 12a... 12e angeschlossen. In jedem der Kanäle 12a...12e wird der Audiosignalanteil des betreffenden Frequenzbereiches in der nachstehend beschriebenen Weise bearbeitet und sodann werden die an Ausgängen 13a...13e abgelieferten bearbeiteten Audiosignalanteile in Eingänge 14a...14e einer Summierschaltung 15 eingespeist, die die bearbeiteten Audiosignalanteile zu dem bearbeiteten rauschverminderten Audiosignal zusammensetzt. Die Summierschaltung 15 weist einen Ausgang 16 auf, der an einen Eingang eines Digital/Analog-Wandlers 17 angeschlossen ist, dessen Ausgang 18 das beispielsweise zur Wiedergabe über einen Lautsprecher geeignete Analogsignal erzeugt.

Die Kanäle 12a...12e sind ebenfalls vorzugsweise Programmteile, die in dem Digitalprozessor ablaufen. Gleichwohl lassen sie sich wie Schaltungsblökke darstellen, da sie den Schaltungsblöcken äquivalente Funktionen ausüben. Der innere Aufbau der Kanäle 12a...12e ist gleich, so daß es genügt, exemplarisch einen der Kanäle 12 zu erläutern.

Der aus dem zugehörigen Ausgang 6...11 kommende digitalisierte Audiosignalanteil gelangt in einen Eingang 19 von Verzögerungsmitteln 21. Dort wird der Audiosignalanteil um eine feste Systemlaufzeit τ verzögert und an einem Ausgang 22 wieder abgegeben. Von hier gelangt der Audiosignalanteil in einen Eingang 23 eines in der Verstärkung steuerbaren Verstärkers 24, dessen Ausgang den Ausgang 13 darstellt.

Der steuerbare Verstärker 24 verfügt über einen Steuereingang 25, über den er aus Steuermitteln 26 ein Verstärkungssteuersignal bekommt. Die Steuermittel 26 geben an ihrem Ausgang 27 ein Signal ab, das sich wie ein Analogsignal verhält, obwohl es digitalisiert ist. Gesteuert werden die Steuermittel an ihrem Eingang 28 über ein lediglich zwei Signalzustände kennendes Digitalsignal, das aus einem Ausgang 29 eines Komparators 31 mit zwei Eingängen 32 und 33 kommt. In den Eingang 33 wird ein Referenz- oder Schwellwert eingespeist, während der Eingang 32 ein Pegelsignal aus einem Ausgang 30 einer Pegelmeßoder -erfassungsschaltung 34 erhält, deren Eingang 35 wiederum mit dem zugehörigen Ausgang 6...11 des als Frequenzweiche wirkenden Schaltungsblocks 5 verbunden ist.

Die Schaltungsblöcke 21, 24, 26, 31, 34 sind, wie bereits erwähnt, vorzugsweise Komponenten eines Digitalprozessors oder Programmteile, die auf dem Digitalprozessor ablaufen. Die Funktionsweise ist wie folgt:

Aufgrund der Digitalisierung des analogen Audiosignals durch den Analog/Digital-Wandler 3 und der nachfolgenden Frequenzanalyse gelangen in den Eingang 19 und in den Eingang 35 jeweils ein Wort bildende Bitsequenzen, deren Wert der Signalamplitude des Audiosignalanteils entspricht. Der zeitliche Abstand aufeinanderfolgender Binärworte ist gleich der Samplingrate des Analog/Digital-Wandlers 3. Bei einer oberen Frequenzgrenze von 20 kHz beträgt der zeitliche Abstand höchstens 25 μsec.

Die eingespeisten Binärzahlen werden aufeinanderfolgend in den Verzögerungsmitteln 21 jeweils um die feste Verzögerungszeit τ verzögert, so daß ein und dasselbe Binärwort mit der Verzögerungszeit τ an dem Ausgang 22 erscheint. Parallel zu der Verzögerung in den Verzögerungsmitteln 21 wird bei 34 mittels der Pegelmeßmittel der Pegel des Audiosignalanteils in dem betreffenden Kanal 12 ermittel. Die Ermittlung des Pegels geschieht gemäß der nachstehenden Gleichung:

$$\text{Pegel}_{(t+\Delta t)} = k * \text{Pegel}_{(t)} + (1-k) * |\text{Audio}_t|,$$

wobei gilt:

| | |
|---|---|
| $k =$ | $\exp(-t_{sample}/t_{integration})$ |
| $t_{sample} =$ | zeitlicher Abstand zwischen zwei Abtastwerten |
| $t_{integration} =$ | Integrationszeitkonstante |
| $\text{Audio}_t =$ | Amplitude des Audiosignalanteils zum Zeitpunkt t. |

Wie unschwer zu erkennen ist, wird bei der Pegelerfassung auch die Vergangenheit mit abnehmender Gewichtung berücksichtigt.

Das so erhaltene gleitende Pegelsignal Pegel$_t$ gelangt in den Komparator 31, wo es mit einem festen oder berechneten Referenzwert verglichen wird. Wenn das Pegelsignal Pegel$_t$ über dem Referenzwert liegt, ist dies ein Anzeichen für einen hinreichenden Signal/Rausch-Abstand, während ein Unterschreiten des Referenzwertes dafür kennzeichnend ist, daß der Signal/Rausch-Abstand den Höreindruck nachteilig beeinflußt.

Für die weitere Beschreibung sei angenommen, daß der Komparator 31 an seinem Ausgang 29 ein high Signal abgibt, wenn das Pegelsignal Pegel$_t$ über dem Grenzwert liegt und nach low wechselt, sobald das Pegelsignal Pegel$_t$ den Referenzwert unterschreitet.

Die nachgeschalteten Steuermittel 26 werten dieses Signal aus, in der Weise, daß sie gemäß der nachstehenden Gleichung die Verstärkung für den in der Verstärkung steuerbaren Verstärker 34 berechnen:

$$\text{Gain}_{(t+\Delta t)} = \text{Scaler} * (\text{Gain}_{(t)} + \text{const.}),$$

wobei gilt:

| | |
|---|---|
| $\text{Scaler} =$ | $\exp(-t_{sample}/t_{Scaler})$ |
| $t_{sample} =$ | zeitlicher Abstand zwischen zwei Abtastwerten |
| $t_{Scaler} =$ | Integrationszeitkonstante |
| $\text{Gain}_t =$ | Verstärkungsfaktor zum Zeitpunkt t |
| $\text{const} =$ | (1/Scaler - 1) * Minimalverstärkung. |

Der gewählte Digitalprozessor arbeitet mit Festkommaarithmetik und hat die Eigenschaft, bei Rechenoperationen selbsttätig das Ergebnis auf einen Größtwert oder einen Kleinstwert, je nachdem, zu begrenzen, ohne daß zusätzliche Vergleichsoperationen erforderlich sind. Der Wert gain$_t$ wird deswegen von dem Digitalprozessor selbsttätig zwischen einem Größtwert, der der Verstärkung "eins" entspricht, und einem Kleinstwert, der der minimalen Verstärkung entspricht, eingeschränkt. Dazwischen sind entsprechend der Registerbreite alle Zwischenwerte zulässig. Somit kann das Ergebnis der Integration nicht über alle Grenzen wachsen und auch nicht beliebig klein werden.

Mit dem auf diese Weise erhaltenen Verstärkungssignal wird der aus dem Ausgang 22 kommende Audiosignalanteil multipliziert.

Aus den oben gegebenen Gleichungen ergeben sich folgende Konsequenzen:

Wenn das Pegelsignal Pegel$_t$ lange genug größer als der Grenzwert gewesen ist, ist das von den Steuermitteln 26 berechnete Verstärkungssteuersignal bei seinem Größtwert, der der Verstärkung eins entspricht, angelangt, was bedeutet, daß der Audiosignalanteil durch die Verzögerungsmittel 21 und den Verstärker 34 ungeschwächt hindurchgelangt. Wird angenommen, daß, ausgehend von dieser Situation, der Signalpegel in dem betreffenden Tonfrequenzbereich allmählich oder sprunghaft abnimmt, wird entsprechend der Integrationszeitkonstanten das Pegelsignal Pegel$_t$ über die Zeit entsprechend abnehmen und irgendwann den Schwellwert unterschreiten, woraufhin das Signal am Ausgang des Komparators 31 von high nach low wechselt. Die Steuermittel 26 beginnen daraufhin entsprechend der obigen Gleichung abwärts zu integrieren, wozu die Konstante const. mit negativem Vorzeichen eingesetzt wird. Dieses Abwärtsintegrieren wird solange fortgesetzt, bis entweder der kleinste Zahlenwert erreicht wird, den der Digitalprozessor erzeugt, oder bis das Signal, das aus dem Komparator 31 kommt, wieder von low nach high zurückwechselt. Sobald dieses Ereignis eintritt, werden die Steuermittel 26 die Integrationsrichtung ändern und nach oben integrieren. Eine Integration nach unten bedeutet eine Abschwächung des Signals, das durch den Verstärker 24 hindurchgelangt.

Da nicht nur der Nutzsignalanteil, sondern auch der Rauschanteil entsprechend vermindert werden, verringert sich der subjektive Rauschgehalt des Gesamtsignals an dem Ausgang 18, wenn beispielsweise der durch Rauschen gestörte Kanal 12a...12e, der auch kein Nutzsignal führt, abgeschwächt ist.

In jedem Falle ändert sich die Verstärkung durch den Verstärker 34 nicht sprunghaft, sondern allmählich, was einem Pumpen wirksam entgegenwirkt. Das Ein- oder Ausblenden des über den betreffenden Kanal 12a...12e übertragenen Audiosignalanteils ist praktisch unhörbar.

Aus den obigen Gleichungen ist ferner erkennbar, daß in Echtzeit nur vergleichsweise sehr wenige Rechenoperationen erforderlich sind, um zu dem gewünschten Erfolg zu kommen.

Schließlich zeigt das System infolge der Verwendung der Verzögerungsmittel 21 nicht-kausales Verhalten, insofern als es bereits beginnt, den betreffenden Kanal 12a...12e durch Verminderung der Verstärkung auszublenden, noch ehe deutlich hörbar in dem betreffenden Kanal 12a...12e kein Nutzsignal mehr vorhanden ist bzw. umgekehrt, den Kanal 12...12e wieder aufzusteuern, bevor das Nutzsignal erscheint, so daß kein Nutzsignal verlorengeht. Das Aufsteuern des Kanals 12a...12e noch vor dem Erscheinen des Nutzsignals ist wegen des zeitlichen Überdeckungseffektes für den Störabstand bedeutungslos, verbessert aber die subjektive Tonqualität.

Obzwar das dargestellte Ausführungsbeispiel überwiegend in Verbindung mit einem Digitalprozessor erläutert ist, leuchtet ohne weiteres ein, daß ein Teil der Vorteile auch erreicht werden kann, wenn anstelle des Digitalprozessors und einer digitalen Signalverarbeitung eine analoge Signalverarbeitung zur Anwendung kommt. Hinsichtlich der digitalen Signalverarbeitung hat das neue Rauschunterdrückungssystem den Vorteil, bei gegebenem Störabstand die Verwendung eines Analog/Digital- bzw. Digital/Analog-Wandlers zu ermöglichen, der weniger Stufen aufweist und deswegen deutlich schneller bzw. kostengünstiger ist.

Das oben ausführlich beschriebene Ausführungsbeispiel stellt die Erläuterung eines sehr wirkungsvoll arbeitenden Systems dar, weil in schmalen Bändern das Rauschen unterdrückt wird, in denen gegebenenfalls kein Nutzsignal, sondern nur Rauschen auftritt. Es ist aber auch denkbar, die Frequenzweiche 5 wegzulassen und das gesamte Hörspektrum durch einen einzigen Kanal zu schicken. Dieser Kanal verarbeitet dann das Spektrum zwischen 30 Hz und 20 kHz, wobei die Regelung immer nur auf das lauteste Signal anspricht und den Kanal leise regelt, gleichgültig in welchem Frequenzbereich das Signal auftritt.

Bei einer neuen Schaltungsanordnung zur Verbesserung des Störabstandes wird das gesamte Tonfrequenzspektrum in mehrere aneinander angrenzende Frequenzkanäle aufgeteilt. In jedem Kanal wird der entsprechende Signalanteil verzögert auf einen in der Verstärkung veränderbaren Verstärker gegeben. Der Verstärker wird, abhängig von einem Komparator, in der Verstärkung geregelt, und zwar so, daß wenn das Tonfrequenzsignal in dem betreffenden Kanal über eine festgelegte Zeit unter einem Schwellwert liegt, die Verstärkung des der Verstärkung veränderbaren Verstärkers allmählich auf einen kleinsten Verstärkungswert heruntergefahren wird. Umgekehrt wird die Verstärkung allmählich auf einen Größtwert hochgesteuert, wenn das Nutzsignal erneut den Schwellwert übersteigt.

## Patentansprüche

1. Schaltungsanordnung zur Verbesserung des Störabstands eines Audiosignals, wobei die Schaltungsanordnung wenigstens einen Kanal umfaßt über den zumindest ein Teil des hörbaren Tonfrequenzspektrums oder das gesamte hörbare Tonfrequenzspektrum geleitet wird, wobei jeder Kanal

   - Pegelmeßmittel (34) zum Erfassen eines Signalpegels in dem Kanal (12) und zum Erzeugen eines Pegelsignals;
   - Vergleichsmittel (31) zum Vergleichen des Pegelsignals mit einem für den Kanal spezifischen Grenzwert und zum Erzeugen eines Schaltsteuersignals, das einen ersten Wert annimmt, wenn der Signalpegel über dem Grenzwert liegt und das einen zweiten Wert annimmt, wenn der Signalpegel unter dem Grenzwert liegt;
   - Signalverstärkungsmittel (24), die einen Eingang (23) zum Einspeisen des Audiosignalanteils und einen Ausgang (13) zum Abgeben des Audiosignalanteils an eine nachgeordnete Schaltung sowie eine einstellbare Verstärkung für den vom Eingang (23) zu dem Ausgang (13) übertragenen Audiosignalanteil aufweisen, die durch ein den Signalverstärkungsmitteln (24) zugeführtes Verstärkungssteuersignal zwischen einem vorgegebenen Minimalwert der Verstärkung und einem vorgegebenen Maximalwert der Verstärkung im wesentlichen stufenlos einstellbar ist; und
   - Steuermittel (26), in die das Schaltsteuersignal eingespeist wird und die abhängig von dem Schaltsteuersignal das Verstärkungssteuersignal für die Signalverstärkungsmittel erzeugen;

beinhaltet und

**dadurch gekennzeichnet, daß**

- zwischen dem Eingang (23) der Signalverstärkungsmittel (24) und dem Eingang (35) der Pegelmeßmittel (34) eine Verzögerungseinrichtung (21) angeordnt ist; und
- nach einem Wechsel des Zustands des Schaltsteuersignals aus dem ersten Zustand in den zweiten Zustand das Verstärkungssteuersignal die Verstärkung nach einer exponentiellen Funktion in Richtung des Minimalwertes der Verstärkung steuert und dort solange hält, wie der zweite Zustand anhält, oder nach einem Wechsel des Zustands des Schaltsteuersignals aus dem zweiten in den ersten Zustand das Verstärkungssteuersignal die Verstärkung nach einer exponentiellen Funktion in Richtung des Maximalwerts der Verstärkung steuert und dort solange hält, wie der erste Zustand anhält.

2. Schaltungsanordung nach Anspruch 1, **dadurch gekennzeichnet,**

- **daß** Frequenzweichenmittel (5) vorgesehen sind, die das Tonfrequenzspektrum des Audiosignals in wenigstens zwei Tonfrequenzbereiche (6...11) aufteilen.

3. Schaltungsanordnung nach Anspruch 1 oder 2, **dadurch gekennzeichnet,**

- **daß** die Verzögerungszeit des Verzögerungsmittels (21) so gewählt wird, daß die Änderung der Verstärkung des Signalverstärkungsmittels (24) zumindest bereits begonnen hat, wenn das Signal, das zur Erzeugung eines Schaltsteuersignals geführt hatte, den Eingang (23) des Signalverstärkermittels erreicht.

4. Schaltungsanordnung nach einem der Ansprüche 1 bis 3, **dadurch gekennzeichnet,**

- **daß** das Pegelsignal nach folgender Formel berechnet wird:

$$\text{Pegel}_{(t+\Delta t)} = k * \text{Pegel}_{(t)} + (1-k) * | \text{Audio}_t |,$$

wobei gilt:

| | |
|---|---|
| $k =$ | $\exp(-t_{sample}/t_{integration})$ |
| $t_{sample} =$ | zeitlicher Abstand zwischen zwei Abtastwerten |
| $t_{integration} =$ | Integrationszeitkonstante |
| $\text{Audio}_t =$ | Amplitude des Audiosignalanteils zum Zeitpunkt t. |

5. Schaltungsanordnung nach einem der Ansprüche 1 bis 3, **dadurch gekennzeichnet,**

- **daß** die Verstärkung der Signalverstärkungsmittel nach folgender Formel berechnet wird:

$$\text{Gain}_{(t+\Delta t)} = \text{Scaler} * (\text{Gain}_{(t)} + \text{const})$$

wobei gilt:

| | |
|---|---|
| Scaler = | $\exp(-t_{sample}/t_{Scaler})$ |
| $t_{sample} =$ | zeitlicher Abstand zwischen zwei Abtastwerten |
| $t_{Scaler} =$ | Integrationszeitkonstante |
| $\text{Gain}_t =$ | Verstärkungsfaktor zum Zeitpunkt t |
| const = | (1/Scaler - 1) * Minimalverstärkung |

6. Schaltungsanordnung nach Anspruch 5, **dadurch gekennzeichnet, daß**

- für den Parameter Scaler zwei verschiedene Werte verwendet werden, je nachdem die Verstärkung erhöht oder vermindert wird.

**Claims**

1. Circuit arrangement for improving the signal-to-noise ratio of an audio signal, where the circuit arrangement comprises at least one channel used to conduct at least part of the audible audio frequency spectrum or the entire audible audio frequency spectrum, where each channel comprises

- level measuring means (34) for detecting a signal level in the channel (12) and for producing a level signal;
- comparison means (31) for comparing the level signal with a limit value which is specific to the channel and for producing a switching control signal which assumes a first value when the signal level is above the limit value and which assumes a second value when the signal level is below the limit value;
- signal amplification means (24) which have an input (23) for feeding in the audio signal component and an output (13) for outputting the audio signal component to a downstream circuit, and also an adjustable gain for the audio signal component transmitted from the input (23) to the output (13), said gain being able to be adjusted essentially continuously between a prescribed minimum value for the gain and a prescribed maximum value for the gain by a gain control signal which is supplied to the signal amplification means (24); and
- control means (26) into which the switching control signal is fed and which produce the gain control signal for the signal amplification means on the basis of the switching control signal; and

**characterized in that**

- a delay device (21) is arranged between the input (23) of the signal amplification means (24) and the input (35) of the level measuring means (34); and,
- following a change in the switching control signal state from the first state to the second state, the gain control signal controls the gain according to an exponential function in the direction of the minimum value of the gain and holds it there for as long as the second state lasts, or, following a change in the switching control signal state from the second to the first state, the gain control signal controls the gain according to an exponential function in the direction of the maximum value for the gain and holds it there for as long as the first state lasts.

2. Circuit arrangement according to Claim 1, **characterized**

- **in that** frequency filter means (5) are provided which split the audio frequency spectrum for the audio signal into at least two audio frequency ranges (6...11).

3. Circuit arrangement according to Claim 1 or 2, **characterized**

- **in that** the delay time of the delay means (21) is chosen such that the change in the gain of the signal amplification means (24) has at least already started when the signal which had resulted in a switching control signal being produced reaches the input (23) of the signal amplifier means.

4. Circuit arrangement according to one of Claims 1 to 3, **characterized**

- **in that** the level signal is calculated on the basis of the following formula:

$$\text{level}_{(t+\Delta t)} = k*\text{level}_{(t)} + (1-k)*|\text{Audio}_t|,$$

where k = $\exp(-t_{sample}/t_{integration})$
$t_{sample}$ = time interval between two samples
$t_{integration}$ = integration time constant
$\text{Audio}_t$ = amplitude of the audio signal component at time t.

5. Circuit arrangement according to one of Claims 1 to 3, **characterized**

- **in that** the gain of the signal amplification means is calculated on the basis of the following formula:

$$\text{Gain}_{(t+\Delta t)} = \text{Scalar} * (\text{Gain}_{(t)} + \text{const})$$

where

Scaler = $\exp(-t_{sample}/t_{Scaler})$
$t_{sample}$ = time interval between two samples
$t_{Scaler}$ = integration time constant
$\text{Gain}_t$ = gain factor at time t
const = (1/Scaler-1)*minimum gain

6. Circuit arrangement according to Claim 5, **characterized in that**

- two different values are used for the Scaler parameter, according to whether the gain is increased or reduced.

**Revendications**

1. Circuit pour améliorer le rapport signal / bruit d'un signal audio, où le circuit comprend au moins un canal par lequel est acheminée au moins une partie du spectre des fréquences acoustiques audibles ou la totalité du spectre des fréquences acoustiques audibles et où chaque canal comprend :

- un moyen (34) de mesure de niveau, pour déterminer le niveau du signal dans le canal (12) et pour produire un signal de niveau ;
- un moyen (31) de comparaison, pour comparer le signal de niveau avec une valeur de seuil spécifique pour le canal et pour produire un signal de commande du circuit qui prend une première valeur quand le niveau du signal se trouve au-dessus de la valeur de seuil et qui prend une seconde valeur quand le niveau du signal se trouve en dessous de la valeur de seuil ;
- un moyen (24) d'amplification du signal qui comporte une entrée (23) pour enregistrer la partie du signal audio et une sortie (13) pour fournir la partie du signal audio à un circuit agencé en aval et qui permet une amplification ajustable de la partie du signal audio transmise de l'entrée (23) vers la sortie (13), le signal de commande de l'amplification acheminé par le moyen (24) d'amplification du signal étant ajustable d'une manière sensiblement progressive entre une valeur minimale prédéterminée de l'amplification et une valeur maximale prédéterminée de l'amplification ; et

- un moyen (26) de commande dans lequel est enregistré le signal de commande du circuit et qui produit le signal de commande de l'amplification pour le moyen d'amplification du signal en fonction du signal de commande du circuit ;

et qui est **caractérisé en ce que**

- entre l'entrée (23) du moyen (24) d'amplification du signal et l'entrée (35) du moyen (34) de mesure du niveau, il est prévu une installation (21) de retardement ; et **en ce que**
- après un changement de l'état du signal de commande du circuit du premier état vers le second état, le signal de commande de 1'amplification modifie l'amplification selon une fonction exponentielle dans la direction de la valeur minimale de l'amplification et l'y maintient aussi longtemps que le second état persiste ou après un changement de l'état du signal de commande du circuit du second état vers le premier état, le signal de commande de l'amplification modifie l'amplification selon une fonction exponentielle dans la direction de la valeur maximale de l'amplification et l'y maintient aussi longtemps que le premier état persiste.

2. Circuit selon la revendication 1, **caractérisé en ce que**

- un moyen (5) diviseur de la fréquence est prévu pour partager le spectre des fréquences acoustiques du signal audio au moins en deux régions de fréquences acoustiques (6 ... 11).

3. Circuit selon la revendication 1 ou la revendication 2, **caractérisé en ce que**

- le temps de retardement du moyen (21) de retardement est choisi de manière à ce que la modification de l'amplification du moyen (24) d'amplification du signal ait déjà au moins commencé quand le signal utilisé pour produire un signal de commande de circuit a atteint l'entrée (23) du moyen d'amplification du signal.

4. Circuit selon l'une des revendications 1 à 3, **caractérisé en ce que**

- le signal de niveau est calculé d'après la formule suivante :

$$\text{Niveau}_{(t+\Delta t)} = k * \text{Niveau}_{(t)} + (1-k)* |\text{Audio}_t|,$$

dans laquelle :

| | |
|---|---|
| k = | $\exp(-t_{sample} / t_{integration})$ |
| $t_{sample}$ = | intervalle de temps entre deux valeurs échantillonnées |
| $t_{integration}$ = | constante de temps d'intégration |
| $\text{Audio}_t$ = | Amplitude de la partie du signal audio au point de temps t |

5. Circuit selon l'une des revendications 1 à 3, **caractérisé en ce que** :

- l'amplification par le moyen d'amplification du signal est calculée d'après la formule suivante :

$$\text{Gain}_{(t+\Delta t)} = \text{Scaler}* (\text{Gain}_{(t)} + \text{const})$$

dans laquelle :

| | |
|---|---|
| Scaler = | $\exp(-t_{sample} / t_{Scaler})$ |
| $t_{sample}$ = | intervalle de temps entre deux valeurs échantillonnées |
| $t_{Scaler}$ = | constante de temps d'intégration |
| $\text{Gain}_t$ = | Facteur d'amplification au point de temps t |
| const = | (1 / Scaler - 1)* amplification minimale |

6. Circuit selon la revendication 5, **caractérisé en ce que**

- on utilise pour le paramètre « Scaler » deux valeurs différentes, respectivement selon que l'amplification est augmentée ou diminuée.

Fig. 1

EP 0 779 706 B1

Fig. 2